# EUROPÄISCHE PATENTANMELDUNG

(11) **EP 3 557 633 A1**
(43) Veröffentlichungstag der Anmeldung: **23.10.2019**
(21) Anmeldenummer: 19167287.2
(22) Anmeldetag: 04.04.2019
(51) Int. Cl.: H01L 29/94, H01L 21/02, H01L 21/28, H01L 49/02, H01L 29/66

(54) **HOCHVOLT-KONDENSATOR ZUR INTEGRATION IN ELEKTRISCHE LEISTUNGSMODULE SOWIE VERFAHREN ZUR HERSTELLUNG**

(30) Priorität: 20.04.2018 DE 102018206061
(71) Anmelder: Fraunhofer-Gesellschaft zur Förderung der angewandten Forschung e.V., 80686 München (DE)
(72) Erfinder: Erlbacher, Tobias, 91099 Poxdorf (DE)
(74) Vertreter: Gagel, Roland

(57) **Zusammenfassung**

Ein Hochvolt-Kondensator zur Integration in elektrische Leistungsmodule weist eine Siliziumschicht (1) auf, in die auf einer Vorderseite eine Anordnung von Vertiefungen (2) eingebracht ist. Die Vorderseite mit den Vertiefungen (2) ist mit einer dielektrischen Schicht (3) oder Schichtfolge beschichtet, wobei die Vertiefungen (2) mit einem elektrisch leitfähigen Material aufgefüllt sind. Die Siliziumschicht (1) trägt auf der Vorderseite und der Rückseite jeweils eine Kontaktmetallisierung (5) zur elektrischen Kontaktierung des Kondensators. Zwischen der Siliziumschicht (1) und der dielektrischen Schicht (3) oder Schichtfolge ist eine Schicht (7) aus thermischem SiO₂ ausgebildet. Die dielektrische Schicht (3) oder Schichtfolge weist eine Schichtdicke von ≥ 1000nm auf und ist aus einem ferroelektrischen oder antiferroelektrischen Material gebildet. Der vorgeschlagene Hochvolt-Kondensator weist eine hohe Integrationsdichte bei hoher Kapazität und guter Entwärmbarkeit auf.

## Beschreibung

### Technisches Anwendungsgebiet

Die vorliegende Erfindung betrifft einen Hochvolt-Kondensator zur Integration in elektrische Leistungsmodule, der eine Siliziumschicht aufweist, in der auf einer Vorderseite eine Anordnung von Vertiefungen eingebracht ist, wobei die Vorderseite mit den Vertiefungen mit einer dielektrischen Schicht oder Schichtfolge beschichtet ist, die Vertiefungen mit einem elektrisch leitfähigen Material aufgefüllt sind und die Siliziumschicht auf der Vorderseite und der Rückseite jeweils eine Kontaktmetallisierung trägt.

In der Leistungselektronik werden Kondensatoren benötigt, die eine hohe elektrische Leistung und hohe elektrische Spannungen vertragen. Diese Hochvolt-Kondensatoren müssen eine gute Entwärmbarkeit aufweisen und sollten möglichst zusammen mit den anderen Leistungshalbleiterbauelementen auf einem gemeinsamen Halbleitersubstrat integriert werden können.

### Stand der Technik

Für den Einsatz in der Leistungselektronik eignen sich Hochvolt-Keramikkondensatoren mit einem Mehrschichtaufbau, wie sie beispielsweise aus M.-J. Pan et al., "A Brief Introduction to Ceramic Capacitors", IEEE Electrical Insulation Magazine, Vol.26, No.3 (2010), Seiten 44 bis 50 bekannt sind. Bei derartigen Mehrschicht-Keramikkondensatoren (MLCC: Multi-Layer-Cofired-Ceramics) werden keramische Schichten auf metallische Leiter aufgebracht und zur Erzielung einer hohen Integrationsdichte übereinander gestapelt. Durch Einsatz (anti-)ferroelektrischer Keramiken mit sehr hoher Dielektrizitätskonstante (> 100) lassen sich hohe Kapazitätswerte auf kleinem Raum erzeugen. Allerdings weisen derartige Mehrschicht-Keramikkondensatoren eine schlechte Entwärmbarkeit und dadurch eine geringe Wechselspannungsbelastbarkeit bzw. niedrige Toleranz gegen Stromwelligkeit auf. Für leistungselektronische Anwendungen muss daher die Kapazität entsprechend überdimensioniert werden.

Die US 7738226 B2 offenbart einen Hochvolt-Silizium-Kondensator, bei dem die Ober- oder Vorderseite des Siliziumsubstrats eine Grabenstrukturierung aufweist, um die Oberfläche zu vergrößern. Auf die Vorderseite mit den Gräben ist eine dielektrische Schicht aufgebracht. Die Gräben sind mit einem elektrisch leitfähigen Material wie beispielsweise Polysilizium aufgefüllt und das Siliziumsubstrat auf der Vorder- und der Rückseite jeweils mit einer Kontaktmetallisierung versehen. Als Materialien für die dielektrische Schicht werden Siliziumdioxid und Siliziumnitrid vorgeschlagen. Auch auf den möglichen Einsatz dielektrischer Schichten mit hoher Dielektrizitätskonstante wird hingewiesen. Die Druckschrift macht jedoch keinerlei Angaben zur Dicke der dielektrischen Schichten und der Problematik der Zuverlässigkeit des Bauelements bei höheren Schichtdicken.

Die Aufgabe der vorliegenden Erfindung besteht darin, einen Hochvolt-Kondensator zur Integration in elektrische Leistungsmodule anzugeben, der eine hohe Integrationsdichte bei guter Entwärmbarkeit ermöglicht und eine ausreichend hohe Zuverlässigkeit für den Einsatz in elektrischen Leistungsmodulen aufweist.

### Darstellung der Erfindung

Die Aufgabe wird mit dem Hochvolt-Kondensator und dem Verfahren gemäß den Patentansprüchen 1 und 10 gelöst. Vorteilhafte Ausgestaltungen des Hochvolt-Kondensators sind Gegenstand der abhängigen Patentansprüche oder lassen sich der nachfolgenden Beschreibung sowie dem Ausführungsbeispiel entnehmen.

Der vorgeschlagene Hochvolt-Kondensator weist eine Siliziumschicht auf, in die auf der Vorderseite eine Anordnung von Vertiefungen eingebracht ist. Die Siliziumschicht wird vorzugsweise durch ein Siliziumsubstrat oder einen Bereich eines Siliziumsubstrats gebildet. Unter der Vorderseite ist hierbei willkürlich die Seite zu verstehen, an der die Vertiefungen in die Siliziumschicht eingebracht sind. Die gegenüberliegende Seite wird dann im Folgenden als Rückseite bezeichnet. Die Vertiefungen können beispielsweise als nebeneinander verlaufende Gräben, insbesondere in paralleler oder auch in konzentrischer Anordnung, ausgebildet sein. Auch andere Geometrien wie beispielsweise an der Oberfläche im Querschnitt rechteckförmige Vertiefungen können ausgebildet sein. Die Vorderseite mit den Vertiefungen ist mit einer dielektrischen Schicht oder dielektrischen Schichtfolge beschichtet. Diese dielektrische Schicht oder Schichtfolge bedeckt somit sowohl die Seiten- und ggf. Bodenwandungen der Vertiefungen als auch die Oberflächenbereiche zwischen den Vertiefungen. Die Vertiefungen mit dieser Beschichtung sind mit einem elektrisch leitfähigen Material aufgefüllt, das vorzugsweise ebenfalls eine zusammenhängende Schicht über der dielektrischen Schicht oder Schichtfolge auf der Vorderseite der Siliziumschicht bildet. Auf die Vorderseite und die Rückseite der Siliziumschicht ist dann jeweils eine Kontaktmetallisierung aufgebracht, über die der Hochvolt-Kondensator elektrisch kontaktiert werden kann. Der vorgeschlagene Hochvolt-Kondensator zeichnet sich dadurch aus, dass zwischen der Siliziumschicht und der dielektrischen Schicht oder Schichtfolge eine Schicht aus thermischem SiO₂ in direktem Kontakt zur dielektrischen Schicht oder Schichtfolge ausgebildet ist, die dielektrische Schicht oder Schichtfolge eine Schichtdicke von ≥ 1000 nm aufweist und die dielektrische Schicht oder Schichtfolge aus einem ferroelektrischen oder antiferroelektrischen Material gebildet ist oder ein ferroelektrisches oder antiferroelektrisches Material enthält.

Durch die Ausbildung des Hochvolt-Kondensators mit der obigen Vertiefungsstruktur und der hohen Schichtdicke der dielektrischen Schicht oder Schichtfolge aus einem ferro- oder antiferroelektrischen Material als Kondensatordielektrikum wird eine hohe Integrationsdichte bei hohen Kapazitätswerten erreicht. Die bei hohen Schichtdicken ferroelektrischer oder antiferroelektrischer Materialien auftretenden Probleme werden durch die Nutzung des thermischen Oxids (SiO₂) weitgehend umgangen, da durch diese Zwischenschicht Grenzflächenzustände im Silicium vermieden werden, die während des Betriebs durch erhöhten Stromfluss in der dielektrischen Schicht zu Defekten und einer Degradation des Isolators führen können. Dadurch wird eine hohe Zuverlässigkeit des Kondensators erreicht.

Aufgrund seines Aufbaus lässt sich der vorgeschlagene Kondensator auf einfache Weise auf Leistungshalbleitersubstraten, insbesondere auf DCB-Substraten (DCB: Direct Copper Bonding), integrieren und man erreicht dadurch aufgrund der großen thermischen Kontaktfläche über die Rückseite des Halbleiter- bzw. Siliziumchips eine sehr gute Entwärmbarkeit. Der Kondensator lässt sich zusammen mit Leistungshalbleiterbauelementen auch auf keramischen Transfersubstraten montieren. Durch den vorgeschlagenen Aufbau werden hohe Kapazitäten von > 200nF und damit eine hohe Integrationsdichte auch bei Anwendungen mit Spannungen von 600 Volt oder darüber erreicht. Dadurch lässt sich der vorgeschlagene Kondensator aufgrund seines geringen Platzbedarfs wirtschaftlich in Leistungsmodulen einsetzen. Auch der Einsatz als Zwischenkreiskondensator wird dadurch wirtschaftlich sinnvoll.

In einer bevorzugten Weiterbildung des vorgeschlagenen Kondensators wird zwischen der dielektrischen Schicht oder Schichtfolge und der Kontaktmetallisierung auf der Vorderseite eine Schicht aus einem anderen dielektrischen Material, insbesondere aus SiO₂ oder Si₃N₄, eingesetzt. Durch die Kombination des ferro- oder antiferroelektrischen Kondensatordielektrikums mit einer derartigen weiteren dielektrischen Schicht wird eine Erhöhung der Spannungsfestigkeit sowie eine Stresskompensation erreicht, die zu einer weiteren Erhöhung der Zuverlässigkeit des Bauelements führt. Dies kann auch durch Bildung der dielektrischen Schichtfolge aus mehreren Schichten aus dem ferroelektrischen oder antiferroelektrischen Material mit zwischenliegenden dielektrischen Schichten aus einem oder mehreren anderen Materialien, insbesondere aus SiO₂ und/oder Si₃N₄, erreicht werden. Eine derartige Kombination der Schichten ermöglicht auch entweder eine Erhöhung der Abscheiderate oder eine weitere Verringerung von Defekten bei der Abscheidung, da sie die Nukleation der Abscheidung des Ferro- bzw. Antiferrodielektrikums beeinflusst.

Bei dem Verfahren zur Herstellung des vorgeschlagenen Hochvolt-Kondensators wird die dielektrische Schicht oder Schichtfolge durch konforme (isotrope) Abscheidung, vorzugsweise mittels MOCVD (MOCVD: Metallo-Organic Chemical Vapour Deposition), erzeugt. Als Materialien können beispielsweise Barium-Strontium-Titanat (BST), Blei-Zirkon-Titanat (PZT) oder Lanthan-Blei-Zirkon-Titanat (PLZT) zum Einsatz kommen. Dies ist selbstverständlich keine abschließende Aufzählung. Die Strukturierung der Oberfläche der Siliziumschicht bzw. des Siliziumsubstrats erfolgt dabei in bekannter Weise, vorzugsweise durch geeignete Ätzschritte in Verbindung mit einer Maskierung. Die Erzeugung der thermischen SiO₂-Schicht erfolgt durch geeignete Temperaturbehandlung in Sauerstoff oder Wasserdampf, beispielsweise für einen Zeitraum von 30 Sekunden bis 10 Stunden in einem Temperaturbereich zwischen 850°C und 1150°C.

Das Auffüllen der Vertiefungen mit dem elektrisch leitfähigen Material und auch die Herstellung der Kontaktmetallisierungen kann beispielsweise durch Abscheidung von Polysilizium oder durch konforme Metallabscheidung erfolgen. Die Dicke der Kontaktmetallisierung kann derart gewählt werden, dass eine lokale Selbstheilung des Kondensators beim Auftreten von Leckströmen erzielt wird. Die Dicke der Kontaktmetallisierung wird dabei ausreichend dünn gewählt, vorzugsweise im Bereich von 10 bis 30 nm, um bei einem lokalen Kurzschluss bzw. Leckstrom eine starke Aufheizung zu erzielen, durch die das metallische Material lokal verdampft. Der Leckstrom wird dadurch an dieser Stelle unterbunden.

Aufgrund der großen Dicke der dielektrischen Schicht ist ein schnelles Abscheideverfahren wie beispielsweise MOCVD erforderlich, um eine wirtschaftliche Herstellbarkeit des Kondensators zu erreichen. Durch die entsprechend hohen Abscheideraten können jedoch leichter Defekte in der Schicht entstehen, die häufig durch Grenzflächenzustände an der Grenzfläche zum Siliziumsubstrat verursacht werden. Durch die Nutzung der thermischen SiO₂-Schicht zwischen dem Siliziumsubstrat und der dielektrischen Schicht werden derartige Grenzflächenzustände vermieden, so dass durch die hohe Abscheiderate eine deutlich geringere Defektdichte und damit eine höhere Zuverlässigkeit des Kondensators erreicht wird. Die obere Begrenzung der dielektrischen Schicht kann dabei auch mit einem langsameren Abscheideverfahren wie beispielsweise ALD erzeugt werden, um am Übergang zur Elektrode keine Defekte zu erhalten, die an dieser Stelle zu Leckströmen führen können. Dies gilt auch für die Abscheidung der optional zwischen der dieelektrischen Schicht aus dem ferroelektrischen oder antiferroelektrischen Material und der Elektrode eingesetzten Si₃N₄- oder SiO₂-Schicht, die vollständig mit einem langsamen Abscheideverfahren wie ALD (Atomlagenabscheidung) abgeschieden werden kann.

Der vorgeschlagene Hochvolt-Kondensator lässt sich sehr vorteilhaft als Bedämpfungsbauelement oder als Zwischenkreiskondensators auf dem Transfersubstrat (DCB) eines Leistungsmoduls zusammen mit den Leistungsschaltern einsetzen. Auch andere Anwendungen des Hochvolt-Kondensators sind möglich, bei denen eine hohe Spannungsfestigkeit und gute Entwärmbarkeit erforderlich sind.

### Kurze Beschreibung der Zeichnungen

Der vorgeschlagene Hochvolt-Kondensator wird nachfolgend anhand eines Ausführungsbeispiels in Verbindung mit den Zeichnungen nochmals näher erläutert. Hierbei zeigen:
- Fig. 1: einen Querschnitt durch einen Hochvolt-Kondensator gemäß einem Ausführungsbeispiel der vorliegenden Erfindung in schematischer Darstellung; und
- Fig. 2: einen Ausschnitt aus der Darstellung der Figur 1, in dem der Schichtaufbau des vorgeschlagenen Hochvolt-Kondensators erkennbar ist.

### Wege zur Ausführung der Erfindung

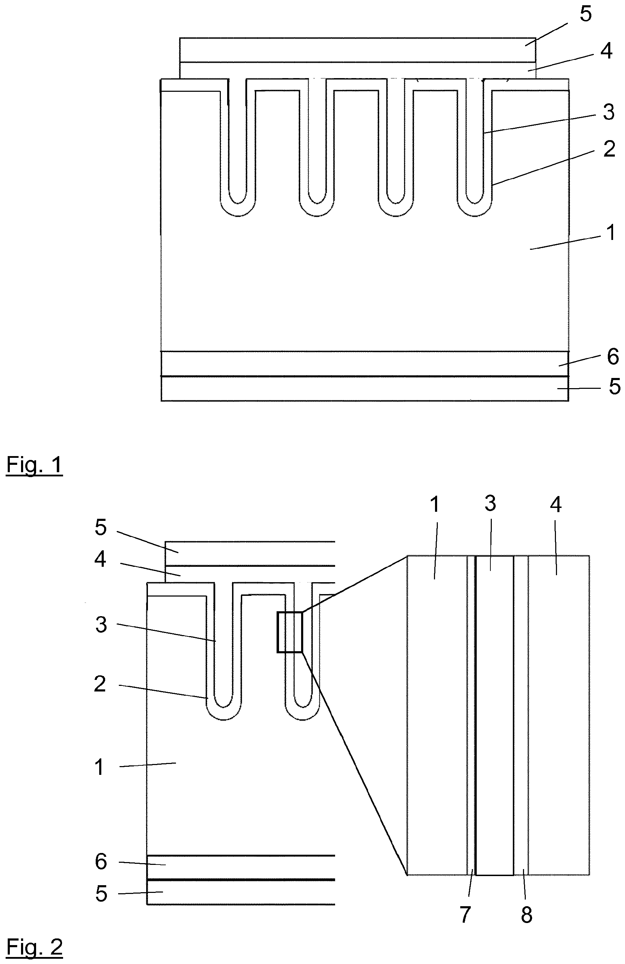

Im Folgenden wird der vorgeschlagene Kondensator für die Leistungselektronik anhand eines Ausführungsbeispiels nochmals näher beschrieben, bei dem der Kondensator in einem Siliziumsubstrat ausgebildet ist. Figur 1 zeigt hierzu eine schematisierte Struktur des in diesem Beispiel dargestellten Kondensators im Querschnitt durch das Siliziumsubstrat 1. In die Vorderseite dieses Siliziumsubstrats 1 sind parallel nebeneinander verlaufende Gräben 2 eingebracht, die ein hohes Aspektverhältnis von ≥ 10:1 (Tiefe zu Breite) aufweisen. Dieses hohe Aspektverhältnis ist aus Gründen der Darstellbarkeit aus der Figur nicht ersichtlich. Die Oberfläche des Siliziumsubstrats 1 einschließlich der Gräben 2 ist mit einer thermischen SiO₂-Schicht bedeckt, die in Figur 1 nicht erkennbar ist. Auf diese Schicht ist eine dielektrische Schicht 3 aus einem ferroelektrischen oder antiferroelektrischen Material mit einer Dicke von ≥ 1000nm aufgebracht, wie dies in Figur 1 schematisch angedeutet ist. Als Materialien können hierzu beispielsweise Barium-Strontium-Titanat oder Blei-Zirkon-Titanat eingesetzt werden. Die Gräben 2 sind mit einem elektrisch leitfähigen Material, beispielsweise mit Polysilizium, verfüllt, das sich auch über die Vorderseite des Siliziumsubstrats 1 erstreckt und eine obere Elektrodenschicht 4 bildet. Die einzelnen Schichten können beispielsweise mittels MOCVD abgeschieden werden. An der Vorder- und der Rückseite des Siliziumsubstrats 1 ist schließlich noch eine Kontaktmetallisierungsschicht 5 zur elektrischen Kontaktierung des Kondensators aufgebracht. An der Rückseite kann zwischen dieser Kontaktmetallisierung 5 und dem Siliziumsubstrat 1 auch noch eine untere Elektrodenschicht 6 aus einem geeigneten elektrisch leitfähigen Material vorhanden sein.

Figur 2 zeigt die Darstellung eines Ausschnitts aus der Querschnittsdarstellung der Figur 1, die den Schichtaufbau zwischen dem Siliziumsubstrat 1 und der oberen Elektrodenschicht 4 bei dem Hochvolt-Kondensator dieses Ausführungsbeispiels zeigt. Aus der Figur ist ersichtlich, dass das Siliziumsubstrat 1 mit einer thermischen Oxidschicht (thermisches SiO₂) 7 beschichtet ist, die somit zwischen der dielektrischen Schicht 3 und dem Siliziumsubstrat 1 liegt. Durch dieses thermische Oxid werden Grenzflächenzustände am Übergang der dielektrischen Schicht 3 zum Siliziumsubstrat 1 vermieden, die zu Defekten in der dielektrischen Schicht 3 führen können. Dadurch wird die Zuverlässigkeit des Kondensators auch bei den hier vorhandenen ferroelektrischen oder antiferroelektrischen Schichten hoher Schichtdicke erhöht. Die dielektrische Schicht 3 aus dem ferroelektrischen oder antiferroelektrischen Material weist eine entsprechend hohe Dielektrizitätskonstante (> 100) auf und ermöglicht eine hohe Sperrspannung des Kondensators. Im vorliegenden Beispiel ist auf diese dielektrische Schicht 3 auch noch eine Schicht 8 aus Siliziumnitrid (Si₃N₄) aufgebracht, die somit zwischen der oberen Elektrodenschicht 4 und der dielektrischen Schicht 3 liegt. Diese vorzugsweise mittels CVD aufgebrachte weitere dielektrische Schicht, die beispielsweise auch aus SiO₂ gebildet sein kann, trägt zu einer Minimierung des Leckstroms an der Grenzfläche zur oberen Elektrode bei.

Mit dem vorgeschlagenen Aufbau des Kondensators wird eine hohe Integrationsdichte bei hoher Spannungsfestigkeit und hohen Kapazitätswerten erreicht, so dass sich der vorgeschlagene Kondensator für leistungselektronische Anwendungen auf einem DCB-Substrat eignet. Die nachfolgende Tabelle 1 zeigt einen Vergleich der Kennwerte eines derartigen Kondensators mit veröffentlichten Kennwerten anderer Hochvolt-Kondensatoren, die Dielektrika aus SiO₂ bzw. Si₃N₄ aufweisen. Aus der Tabelle ist ersichtlich, dass der vorgeschlagene Hochvolt-Kondensator eine sehr hohe Integrationsdichte und Gütezahl gegenüber bisher realisierten Hochvolt-Kondensatoren in Siliziumtechnologie aufweist.

**Tabelle 1**

| Dielektrikum | Durchbruchspannung | Integrationsdichte | Gütezahl |
|---|---|---|---|
| SiO2/Si3N4 | 550 V | 2 nF/mm² | 1,1 µC/mm² |
| SiO2/Si3N4 | 1000 V | 0,7 nF/mm² | 0,7 µC/mm² |
| SiO2/Si3N4 | 500 V | 2,9 nF/mm² | 1,45 µC/mm² |
| SiO2/Si3N4 | 280 V | 3,5 nF/mm² | 0,98 µC/mm² |
| (Anti-)Ferroelektrika | 1000 V | >7 nF/mm² | >7 µC/mm² |

### Bezugszeichenliste

1 Silizium-Substrat
2 Gräben
3 Dielektrische Schicht
4 Obere Elektrodenschicht
5 Kontaktmetallisierung
6 Untere Elektrodenschicht
7 Thermische Oxidschicht (SiO₂)
8 Siliziumnitrid-Schicht

## Patentansprüche

1. Hochvolt-Kondensator zur Integration in elektrische Leistungsmodule, der eine Siliziumschicht (1) aufweist, in die auf einer Vorderseite eine Anordnung von Vertiefungen (2) eingebracht ist, wobei die Vorderseite und die Vertiefungen (2) mit einer dielektrischen Schicht (3) oder Schichtfolge beschichtet sind, die Vertiefungen (2) mit einem elektrisch leitfähigen Material aufgefüllt sind und die Siliziumschicht (1) auf der Vorderseite und der Rückseite jeweils eine Kontaktmetallisierung (5) trägt,
**dadurch gekennzeichnet, dass**
- zwischen der Siliziumschicht (1) und der dielektrischen Schicht (3) oder Schichtfolge eine Schicht (7) aus thermischem SiO₂ in direktem Kontakt zur dielektrischen Schicht (3) oder Schichtfolge ausgebildet ist, und
- die dielektrische Schicht (3) oder Schichtfolge eine Schichtdicke von ≥ 1000 nm aufweist und
- aus einem ferroelektrischen oder antiferroelektrischen Material gebildet ist oder ein ferroelektrisches oder antiferroelektrisches Material enthält.

2. Hochvolt-Kondensator nach Anspruch 1,
**dadurch gekennzeichnet,**
**dass** zwischen der dielektrischen Schicht (3) oder Schichtfolge und der Kontaktmetallisierung (5) auf der Vorderseite eine weitere dielektrische Schicht ausgebildet ist.

3. Hochvolt-Kondensator nach Anspruch 2,
**dadurch gekennzeichnet,**
**dass** die weitere dielektrische Schicht aus SiO₂ oder Si₃N₄ gebildet ist.

4. Hochvolt-Kondensator nach einem der Ansprüche 1 bis 3, **dadurch gekennzeichnet,**
**dass** das elektrisch leitfähige Material zumindest teilweise Polysilizium oder ein metallisches Material ist.

5. Hochvolt-Kondensator nach einem der Ansprüche 1 bis 4, **dadurch gekennzeichnet,**
**dass** die dielektrische Schichtfolge mehrere dielektrische Schichten aus dem ferroelektrischen oder antiferroelektrischen Material mit zwischenliegenden dielektrischen Schichten aus einem oder mehreren anderen Materialien aufweist.

6. Hochvolt-Kondensator nach Anspruch 5,
**dadurch gekennzeichnet,**
**dass** die zwischenliegenden dielektrischen Schichten aus SiO₂ und/oder Si₃N₄ gebildet sind.

7. Hochvolt-Kondensator nach einem der Ansprüche 1 bis 6, **dadurch gekennzeichnet,**
**dass** die Vertiefungen (2) Gräben sind.

8. Hochvolt-Kondensator nach einem der Ansprüche 1 bis 7, **dadurch gekennzeichnet,**
**dass** die Kontaktmetallisierung (5) eine Dicke aufweist, durch die eine lokale Selbstheilung des Kondensators bei Auftreten von Leckströmen erreicht wird.

9. Verwendung eines Hochvolt-Kondensators nach einem oder mehreren der vorangehenden Ansprüche als Bedämpfungsbauelement oder als Zwischenkreiskondensator auf einem Substrat eines elektrischen Leistungsmoduls.

10. Verfahren zur Herstellung eines Hochvolt-Kondensators nach einem der Ansprüche 1 bis 8, bei dem die dielektrische Schicht (3) oder Schichtfolge durch konforme Abscheidung erzeugt wird.
